# EUROPÄISCHE PATENTANMELDUNG

(11) **EP 1 881 086 A1**
(43) Veröffentlichungstag der Anmeldung: **23.01.2008**
(21) Anmeldenummer: 07009352.1
(22) Anmeldetag: 09.05.2007
(51) Int. Cl.: C23C 14/50, C23C 16/458

(54) **Werkstückträger für Vakuumbeschichtungsanlagen mit magnetischen Aufnahmekörpern**

(30) Priorität: 17.07.2006 DE 102006032959
(71) Anmelder: iwis motorsysteme GmbH & Co. KG, 81369 München (DE)
(72) Erfinder: Jörgensen, Gerald, Dr., 82256 Fürstenfeldbruck (DE); Pintoiu, Stefan, 81534 München (DE); Fink, Thomas, Dr., 85221 Dachau (DE); Kohn, Martin, 83714 Miesbach (DE); Vetter, Jörg Dr, 51429 Bergisch Gladbach (DE); Hoffmann, Klaus, 41541 Dormagen (DE); Kranz, Eginhard, 51065 Köln (DE)
(74) Vertreter: Grünecker, Kinkeldey, Stockmair & Schwanhäusser Anwaltssozietät

(57) **Zusammenfassung**

Die Erfindung betrifft einen Werkstückträger für Vakuumbeschichtungsanlagen und einen Werkstückträger mit einem zylindrischen Werkstück. Der Werkstückträger für Vakuumbeschichtungsanlagen mit zumindest einem Trägerkörper, der um eine erste außerhalb des Trägerkörpers befindliche Rotationsachse drehbar gelagert ist und um eine zweite innerhalb des Trägerkörpers befindliche Rotationsachse drehbar gelagert ist, ist dadurch gekennzeichnet, dass der Trägerkörper auf seiner Außenseite mehrere magnetische Aufnahmekörper zur Aufnahme von zu beschichtenden Werkstücken aufweist.

## Beschreibung

Die Erfindung betrifft einen Werkstückträger für Vakuumbeschichtungsanlagen mit zumindest einem Trägerkörper, der um eine erste außerhalb des Trägerkörpers befindliche Rotationsachse drehbar gelagert ist und um eine zweite innerhalb des Trägerkörpers befindliche Rotationsachse drehbar gelagert ist.

Derartige Werkstückträger sind aus dem Stand der Technik etwa aus der DE 19803278 A1 bekannt. Aus dieser Druckschrift ist auch bekannt, dass solche Werkstückträger in Vakuumbeschichtungsanlagen Verwendung finden, um Werkstücke, d.h. dreidimensionale Bauteile, wie z.B. Werkzeuge oder weiter zu verarbeitende Elemente mit einer Beschichtung zu versehen. Hierbei verwendete Beschichtungsverfahren sind etwa PVD-, PECVD oder CVD-Prozesse. Auch andere plasmagestützten Beschichtungsprozesse im Vakuum finden vielfach Anwendung. Die häufigsten aus der Fachliteratur hinlänglich bekannten Prozesse sind jedoch die PVD- (Physical Vapor Deposition) oder CVD-Prozesse (Chemical Vapor Deposition).

Das PVD-Verfahren hat den Vorteil, dass trotz niedriger Prozesstemperatur verschleißbeständige Gleitschichten hergestellt werden, ohne dass sich eine Beeinträchtigung des Grundwerkstoffes ergibt. Bei CVD-Verfahren gibt es ebenfalls die Verfahrensvariante mit niedrigen Prozesstemperaturen, z.B. durch Plasmaaktivierung, um eine Aufbringung der Beschichtung zu ermöglichen. Die Beschichtungen erhöhen die Verschleißresistenz und verbessern die Gleiteigenschaften des beschichteten Werkstücks.

Die Erfindung betrifft auch einen Werkstückträger mit zumindest einem zylindrischen Werkstück.

Aus dem Stand der Technik ist auch eine magnetische Drehvorrichtung offenbart, die als Objektträger in einer Plasmabeschichtungskammer verwendet wird. Eine Vakuumbeschichtungsanlage ist auch aus der EP 1025277 B1 bekannt. Ähnliche Vorrichtungen sind auch aus der DE 10017120 C1, der EP 1598442 A1, der WO 2006/009686 A1, der EP 0470447 A1, der EP 0550003 B1 der DD 265 176 A1, der Zeitschrift Metall, Sonderdruck 3/1994, S 198 ff. und der DE 19635735 C1 bekannt.

Es ist die Aufgabe der vorliegenden Erfindung eine besonders zeit- und kostenoptimierte Bearbeitung im Sinne einer Beschichtung von Werkstücken zu ermöglichen. Die bestehenden Werkstückträger und Vakuumbeschichtungsanlagen haben den Nachteil, dass nur wenige Werkstücke in einem relativ langen Zeitraum beschichtet werden können. Es ist hier die Aufgabe, eine Abhilfe zu schaffen.

Eine gattungsgemäße Lösung der Aufgabe besteht darin, dass der Trägerkörper auf seiner Außenseite mehrere jeweils radial abstehende magnetische Aufnahmekörper zur Aufnahme von zu beschichtenden Werkstücken aufweist, die an ihrer trägerkörperfernen Seite eine Aufnahmefläche für das zu beschichtende Werkstück aufweisen.

Der Vorteil einer solchen Ausgestaltung liegt darin, dass zu beschichtende Werkstücke, z.B. Kettenbolzen in großer Zahl dem Werkstückträger zugeführt werden können, am Werkstückträger von den Aufnahmekörpern jeweils aufgenommen werden, und in Drehung versetzt werden, so dass die Beschichtungspartikel, die vorzugsweise Atome, lonen oder Nanopartikel sind, gleichmäßig und sicher auf dem gesamten Umfang als Verschleißschutz und/oder Gleitbeschichtung aufgebracht werden.

Durch eine solche Anordnung ist sichergestellt, dass die zu bearbeitenden Werkstücke vorzugsweise radial von dem Trägerkörper abstehen. Im Falle der Kettenbolzen steht die Längsachse der Kettenbolzen senkrecht auf der Längsachse des Trägerkörpers. Die Werkstücklängsachsen sind quer zur Längsachse des Trägerkörpers ausgerichtet. Im Betrieb drehen sich die Trägerkörper um eine erste Rotationsachse und um sich selber, also um die zweite Rotationsachse. Die zu beschichtenden Werkstücke, vorzugsweise die Kettenbolzen, drehen sich in einer überlagerten Bewegung durch einen Beschichtungsraum der Vakuumbeschichtungsanlage vorzugsweise gleichmäßig. Die Nanopartikel, mit denen die Werkstücke beschichtet werden, können somit gleichmäßig auf alle nicht vom Aufnahmekörper abgedeckten Bereiche des Werkstücks gelangen. Es ist dadurch sichergestellt, dass fast die gesamte Oberfläche des Werkstücks beschichtbar ist, mit Ausnahme des Bereichs, der an dem Aufnahmekörper direkt anliegt.

Unter Kettenbolzen sind die Bolzen zu verstehen, die einzelne Kettenglieder miteinander verbinden. Solche Kettenbolzen sind im Regelfall aus metallischem Werkstoff, insbesondere aus eisenhaltigem Werkstoff, und vorzugsweise aus Stahl gefertigt. Die Kettenbolzen finden in Steuerketten von Verbrennungsmotoren Verwendung. Dabei verbinden unter anderem die Steuerketten die Kurbelwelle mit der Nockenwelle. Die Steuerkette ist hohen Belastungen ausgesetzt, weswegen die Kettenbolzen eine möglichst gut gleitende Oberfläche aufweisen sollen. Als Beschichtungsverfahren, haben sich PVD-, CVD- oder Plasmaionenbeschichtungsverfahren bewährt. Es wird hier auf die parallele, noch nicht veröffentlichte Patentanmeldung DE 102006024433.8 verwiesen.

Bevorzugte Ausführungsformen werden in den Unteransprüchen näher beschrieben und beansprucht.

Besonders vorteilhaft ist es in einem weiteren Ausführungsbeispiel, wenn der Querschnitt der Aufnahmefläche dem Querschnitt der Werkstücke entspricht. Dadurch ist auch sichergestellt, dass die Werkstücke kippfrei auf der Aufnahmefläche der Aufnahmekörper über die Magnetkraft gehalten wird. Die Werkstücke, insbesondere die Kettenbolzen, stehen dann alle im selben Winkel von dem Trägerkörper ab.

Vorteilhaft ist es auch, wenn in einer weiteren Ausführungsform der Querschnitt der Aufnahmekörper größer als der Querschnitt der Werkstücke ist. Die potenzielle Aufnahmefläche kann in einem solchen Fall größer ausgebildet werden, wodurch die Wahrscheinlichkeit das Werkstück genau, vorzugsweise orthogonal zur zweiten Rotationsachse, zu positionieren, deutlich erhöht wird.

Wenn die Aufnahmekörper zylindrisch ausgeformt sind, so ist in dieser vorteilhaften Ausführungsvariante sichergestellt, dass im Idealfall die Aufnahmekörper und zu bearbeitenden Werkstücke miteinander fluchten, wodurch ein Plasma - bzw. lonenfeld gleichmäßig um die Werkstücke verteilt wird. Eine besonders gleichmäßige Oberfläche nach der Beschichtung der Werkstücke ist die Folge.

Es ist ferner von Vorteil, wenn der Trägerkörper eine Zylinderform aufweist. In dieser Ausführungsform kann auf bereits bestehende Bauteile zurückgegriffen werden.

Aus Kostengründen und Haltbarkeitsgründen hat es sich in einer weiteren Ausführungsform als vorteilhaft herausgestellt, wenn der Aufnahmekörper einen Permanentmagneten umfasst. Andere Arten von Magneten sind jedoch ebenfalls verwendbar, wie etwa elektrisch aktivierte Magnete.

Um ein klar definiertes Magnetfeld zu erreichen, hat es sich auch als vorteilhaft herausgestellt, wenn in einer weiteren vorteilhaften Ausführungsform der Aufnahmekörper magnetisch abgeschirmt ist.

Besonders vorteilhaft ist eine weitere Ausführungsform, in der der Permanentmagnet von zumindest einer Hülse umgeben ist. Ein besonders einfacher Zusammenbau ist dann möglich.

Eine besonders gute magnetische Abschirmung ist dann die Folge, wenn der Permanentmagnet in einer vorteilhaften Ausführungsvariante von zwei Hülsen umgeben ist, die vorzugsweise zueinander koaxial angeordnet sind.

Wenn die Hülse aus magnetisch weichem Material besteht, so wird ein magnetisches Streufeld vermieden. Die Werkstücke sind dann besonders gleichmäßig in diesem Ausführungsbeispiel beschichtet.

Wenn der Permanentmagnet aus magnetisch hartem Material besteht, ist sichergestellt, dass der Permanentmagnet über eine sehr lange Zeit seine Magnetkraft behält und die Haltekraft der Werkstücke über einen langen Zeitraum gleich hoch bleibt, wodurch die Lebensdauer des Werkstückträgers erhöht ist. Der Permanentmagnet ist hohlraumfrei oder porenfrei ausgestaltet und dicht gepresst hergestellt.

Der Einsetzvorgang erfolgt entweder manuell, oder vorzugsweise automatisch. Die Beschickung erfolgt mittels eines klassischen Batch-Anlagenprinzips mit vertikal angeordneten Quellen, oder in einem In-line-Prozess bei Durchtaktung von Kleinchargen. Während die Beschichtungsdauer im klassischen Batch-Prozess, bei dem einzelne Chargen diskontinuierlich bearbeitet werden, zwischen 60 und 300 Minuten dauert, ist die Beschichtungsdauer im In-line-Prozess, bei dem eine kontinuierliche Bearbeitung erfolgt, zwischen 10 und 120 Minuten, wobei dann die Durchtaktung mit Kleinchargen erfolgt. In dem klassischen Batch-Prozess werden Großchargen beschickt. Da die bei der Beschichtung verwendeten Partikel im Regelfall aus einer Richtung kommen, wird bei einem Trägerkörper mit rundem Querschnitt verhindert, dass bei Rotation des Trägerkörpers im Bereich der Kanten des Trägerkörpers, bei dessen Rotation, eine erfolgende Abdeckung der zu beschichtenden Werkstücke zu einer unregelmäßigen Beschichtung führt.

Relativ einfach ausrichten lässt sich der Werkstückträger, wenn der Trägerkörper vertikal ausgerichtet ist. Vorteilhaft ist ferner, wenn die zweite Rotationsachse parallel zur ersten Rotationsachse ausgerichtet ist. Die Werkstücke stehen dann horizontal von dem Trägerkörper ab und unterliegen immer gleichbleibenden Kräften, vorausgesetzt die Geschwindigkeit um die beiden Rotationsachsen bleibt gleich. Eine besonders gute Bedienbarkeit des Werkstückträgers ist die Folge.

In einem weiteren Ausführungsbeispiel ist von Vorteil, wenn die Aufnahmekörper zur Aufnahme der Werkstücke quer zur zweiten Rotationsachse ausgerichtet sind. Eine gute Erreichbarkeit des Werkstücks von den auf die Werkstücke aufzubringenden Partikeln ist dadurch gewährleistet. Die Beschichtung wird bei einer solchen vorteilhaften Ausführungsvariante besonders gleichmäßig.

Eine weitere Ausführungsvariante, hat sich als vorteilhaft herausgestellt, bei der die Aufnahmekörper in Löcher einer Außenwand des Trägerkörpers eingesteckt und fixiert sind.

Von besonderem Vorteil ist es auch, wenn zwischen den Aufnahmekörpern und den Löchern eine Presspassung vorliegt.

Auch ist in einem weiteren Ausführungsbeispiel von Vorteil, wenn zwischen den Permanentmagneten und der Hülse eine Presspassung vorliegt. Alternativ oder zusätzlich zu den Presspassungen lassen sich die Aufnahmekörper vorteilhafterweise auch über Schraubsicherungen am Trägerkörper befestigen. Auch sind andere Klemmlösungen möglich.

Wenn zumindest zwei Trägerkörper vorhanden sind, vorzugsweise auch drei, vier oder mehr Trägerkörper, so lassen sich pro Zeiteinheit mehr Werkstücke, wie etwa Kettenbolzen, beschichten.

Um sicherzustellen, dass alle zu beschichtenden Werkstücke gleichmäßig beschichtet werden, ist es von Vorteil, wenn die Aufnahmekörper gleichmäßig über den Trägerkörper verteilt sind.

Wenn zumindest zwei, vorzugsweise vier Aufnahmekörper zueinander äquidistant auf derselben Höhe des Trägerkörpers angeordnet sind, so lässt sich die zu bearbeitende Werkstückzahl erhöhen.

Noch weiter erhöhen lässt sich die zu bearbeitende Werkstückzahl dann, wenn unter und/oder über einer ersten Lage an Aufnahmekörpern weitere Lagen an Aufnahmekörpern angeordnet sind, deren Aufnahmekörper um 45° zu den Aufnahmekörpern der ersten Lage versetzt angeordnet wird. Dadurch wird der Abstand der Werkstücke zu einander gleich gehalten, was zu einer gleichmäßigen Plasmafeldausdehnung und somit zu einer gleichmäßigen Beschichtung der Werkstücke führt.

Wenn der Trägerkörper über einen Motor angetrieben ist, so lässt sich auf herkömmliche Weise eine Bewegung der Werkstücke erreichen.

Die Erfindung betrifft insbesondere auch einen Werkstückträger mit zumindest vorzugsweise einem zylindrisch ausgestalteten Werkstück, wie etwa einem Kettenbolzen.

Im Weiteren wird die Erfindung anhand einiger Figuren näher erläutert. Es zeigen:
- Fig. 1: einen erfindungsgemäßen Werkstückträger für Vakuumbeschichtungsanlagen in schematischer perspektivischer Ansicht mit Werkstücken, die an einem Trägerkörper des Werkstückträgers über Aufnahmekörper angeordnet sind,
- Fig. 2: eine vergrößerte Darstellung des Werkstückträgers aus Fig. 1 in perspektivischer schematischer Ansicht mit zwei Trägerkörpern,
- Fig. 3: eine Detailansicht eines Aufnahmekörpers, der in die Außenwandung eines Trägerkörpers gesteckt ist,
- Fig. 4: eine Detailansicht eines Aufnahmekörpers mit einem Permanentmagneten und zwei Hülsen, wobei der Aufnahmekörper in ein Loch der Außenwandung eines Trägerkörpers gesteckt ist,
- Fig. 5: eine schematische Detailansicht eines Aufnahmekörpers aus der Fig. 3, wobei der Aufnahmekörper dieselben Querschnittsabmessungen wie das zu bearbeitende Werkstück aufweist, wobei ein trägerkörperfemes Ende des Aufnahmekörpers plan und in Kontakt mit dem zu bearbeitenden Werkstück im Schnitt dargestellt ist und
- Fig. 6: eine Detailansicht im Schnitt eines Aufnahmekörpers mit zwei Hülsen, wobei das Werkstück nur auf der Stirnseite des Permanentmagneten aufsteht.

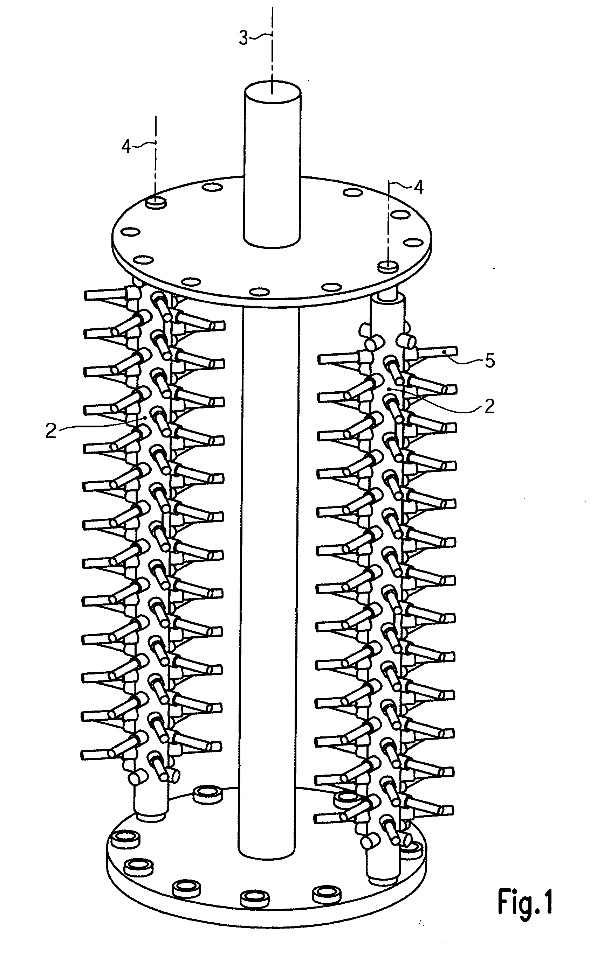

Fig. 1 zeigt einen Werkstückträger 1. Der Werkstückträger 1 weist eine zentrische Säule auf, die an beiden Enden eine runde Platte aufweist. Zwischen den runden Platten, äquidistant beabstandet zu der zentrischen Säule und äquidistant beabstandet zueinander, befinden sich zwei Trägerkörper 2. Ein nicht dargestellter Antriebsmechanismus, mit einem Motor treibt die Platten an, wodurch sich die Trägerkörper 2 um die zentrische Säule auf einer Kreisbahn herumbewegen. Über denselben oder einen anderen, ebenfalls nicht dargestellten Antriebsmechanismus mit dem gleichen, oder einem weiteren Motor, der ebenfalls nicht dargestellt ist, werden die Trägerkörper 2 selbst angetrieben. Die Trägerkörper 2 können mit derselben Geschwindigkeit oder einer anderen Geschwindigkeit relativ zueinander angetrieben werden. Vorzugsweise werden sie mit derselben Geschwindigkeit zueinander angetrieben. Die Winkelgeschwindigkeit der Trägerkörper 2 ist vorteilhafterweise dieselbe, wie die an den Platten anliegende. Auch unterschiedliche Geschwindigkeiten sind aber praktikabel.

Die Trägerkörper 2 rotieren somit auf einer Kreisbahn um eine erste Rotationsachse 3, die im in Fig. 1 dargestellten Fall die Symmetrieachse durch die zentrische Säule ist. Eine zweite Rotationsachse 4 ist deckungsgleich zu einer Symmetrieachse durch jeden der Trägerkörper 2. Die Trägerkörper 2 rotieren somit auch um die zweite Rotationsachse 4, genauso wie um die erste Rotationsachse 3. Die Trägerkörper 2 sind drehbar an der oberen und unteren Platte des Werkstückträgers 1 angebracht. Während im dargestellten Ausführungsbeispiel nur zwei Trägerkörper 2 Verwendung finden, ist es jedoch auch möglich weitaus mehr Trägerkörper, oder auch nur einen Trägerkörper zu nutzen. Die Anzahl der Trägerkörper ist abhängig von dem nötigen gesamten Bewegungsraum der an dem Trägerkörper 2 angebrachten Werkstücke 5. Im vorliegenden Anwendungsfall und in der dargestellten Ausführungsform, sind die Werkstücke 5 als Kettenbolzen ausgebildet. Kettenbolzen sind wie beschrieben vollzylindrische hochbelastbare Verbindungselemente, die bei Steuerketten für Verbrennungsmotoren Anwendung finden.

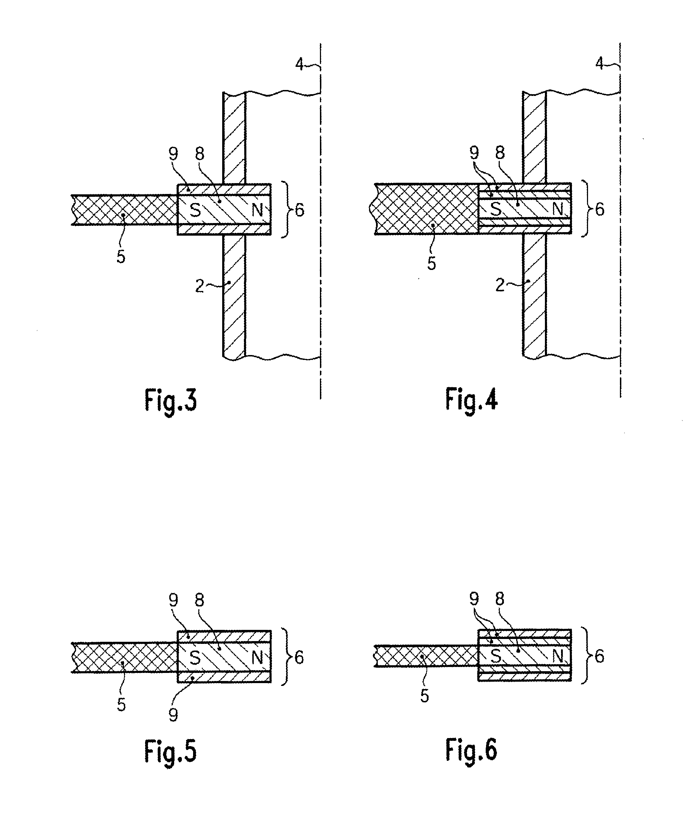

Auf der Außenseite der Trägerkörper 2 sind mehrere magnetische Aufnahmekörper 6 angebracht. Die Aufnahmekörper 6 sind zylindrisch ausgeformt. Die Magnetisierung ist elektrisch oder auf anderem Wege erfolgt. Vorzugsweise werden Permanentmagnete verwendet. Ein Pol, in den Fig. 3 bis 6 als Südpol dargestellt, ist auf der trägerkörperfernen Seite, also dem trägerkörperfernen Ende des Aufnahmekörpers vorhanden, und auf der trägerkörpemahen Seite ist der andere Pol, im vorliegenden Fall der Nordpol. Permanentmagnete haben den Vorteil, dass deren Magnetkraft nicht von einer elektrischen Ladung abhängt, und somit ausfallsicher ist.

Die Aufnahmekörper 6 sind zylindrische, dicht gepresste Magneten 8, die in den Trägerkörper 2, der dann als Stahlzylinder ausgebildet ist, eingesteckt werden.

Die Aufnahmekörper 6 bestehen aus einem Permanentmagneten 8 mit rundem Querschnitt und zylindrischer Ausdehnung und einer oder mehreren optionalen Hülsen 9. Diesen Permanentmagneten 8 umgebend ist die Hülse 9 angeordnet. Die Hülse 9 hat einen kreisringförmigen Querschnitt. Der Innendurchmesser der Hülse 9 entspricht im Wesentlichen dem Außendurchmesser des Permanentmagneten 8. Zwischen der Hülse 9 und dem Permanentmagneten 8 ist eine Presspassung vorhanden. Zwischen der Außenwandung der Hülse 9 und dem Durchmesser des Loches in dem Trägerkörper 2 ist ebenfalls eine Presspassung vorhanden.

Die trägerkörperfernen Enden von der Hülse 9 und dem Permanentmagneten 8 fluchten miteinander. Es ist auch möglich, dass das trägerkörperferne Ende der Hülse 9 über das trägerkörperferne Ende des Permanentmagneten 8 übersteht und somit eine Art Schürze bildet, die zur Zentrierung und Abstützung des Werkstücks, vorzugsweise eines Kettenbolzens dient.

Auf dem Aufnahmekörper 6 wird stirnseitig das Werkstück 5, insbesondere der Kettenbolzen aufgebracht. Der Kettenbolzen steht dann senkrecht zur zweiten Rotationsachse 4 vom Trägerkörper 2 weg. Andere Winkel sind jedoch ebenso denkbar.

Am trägerkörperfernen Ende des Aufnahmekörpers 6 weist der Aufnahmekörper 6 eine Aufnahmefläche 7 auf.

Der Aufnahmekörper 6 besteht vorzugsweise aus demselben Material wie der Trägerkörper 2, also vorzugsweise ebenfalls aus Stahl.

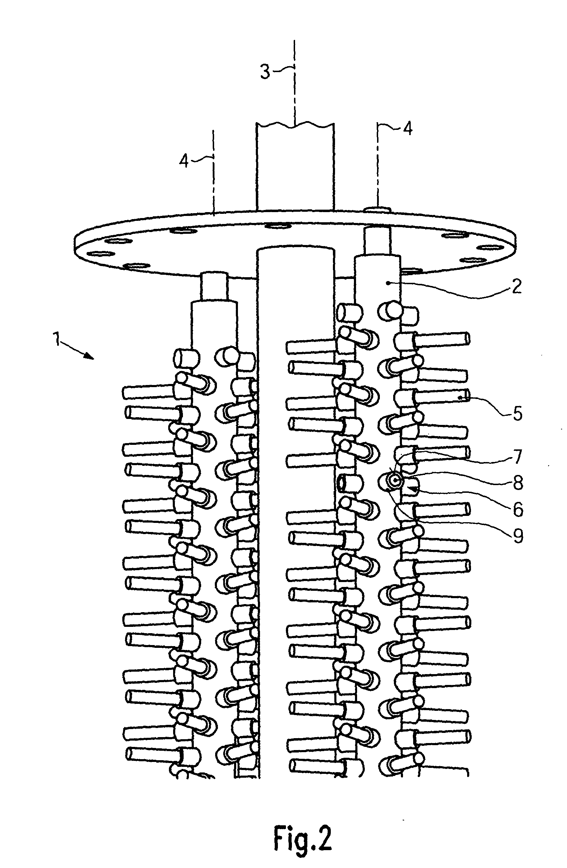

In Fig. 2 ist noch besser ersichtlich, dass jeweils vier Aufnahmekörper 6 zueinander äquidistant auf derselben Höhe auf einem Trägerkörper 2 angebracht sind. Über dieser durch die vier Aufnahmekörper 6 gebildeten Lage an Aufnahmekörpern 6 befindet sich eine weitere Lage an Aufnahmekörpern 6, ebenfalls gebildet durch vier zueinander äquidistant beabstandete Aufnahmekörper 6. Die Aufnahmekörper 6 der ersten Lage sind um 45° zu den Aufnahmekörpern 6 der zweiten Lage versetzt. Dadurch sind die Aufnahmekörper 6 der ersten und zweiten Lage zueinander ebenfalls äquidistant. Die 45°-Versetzung zieht sich nach oben und unten durch die einzelnen Lagen an Aufnahmekörpern 6. Es sind auch andere Versetzwerte, wie etwa 33° oder 66° denkbar. Der 45°-Wert hat sich aufgrund der Äquidistanz am vorteilhaftesten herausgestellt. Der Abstand der Werkstücke zueinander ist dabei wichtig, um eine besonders gleichmäßige Beschichtung zu erreichen.

Fig. 3 zeigt einen durch die Wandung eines Trägerkörpers 2 hindurchgesteckten Aufnahmekörper 6. Der Aufnahmekörper 6 weist dabei einen Außendurchmesser auf, der geringfügig kleiner als der Lochdurchmesser in dem Trägerkörper 2 ist. Es lassen sich auch zusätzlich oder alternativ Bolzen- oder Schraubsicherungen verwenden.

In Fig. 4 ist eine solche alternative Befestigungsart mit zwei Hülsen 9 dargestellt.

Der Kettenbolzen steht dabei stirnseitig auf beiden Hülsen 9 und auf dem Permanentmagneten 8 auf. Es ist jedoch auch möglich, dass die trägerkörperfernen Enden der Hülsen 9 nicht mit dem trägerkörperfernen Ende des Permanentmagneten 8 bündig enden, sondern über den Permanentmagneten 8 überstehen. Das Werkstück 5, vorzugsweise der Kettenbolzen, steht dann lediglich stirnseitig auf dem Permanentmagneten 8 auf und ist innerhalb des Überstandes der Hülsen 9 befindlich. Dies dient der besseren Zentrierung und zur Erhöhung der Haltekraft, wenn zwischen dem Innendurchmesser der inneren Hülse 9 und dem Außendurchmesser des Werkstücks 5, vorzugsweise dem Kettenbolzen, eine entsprechende Passung, wie etwa eine Presspassung gewählt ist.

In der Fig. 3 ist das zu beschichtende Werkstück 5, nämlich der Kettenbolzen vom Au-βendurchmesser her gleich wie der Permanentmagnet 8 des Aufnahmekörpers 6 dimensioniert. Der Kettenbolzen steht dann stirnseitig auf dem trägerkörperfernen Ende des Permanentmagneten 8 auf und wird durch die Magnetkraft an dem Aufnahmekörper 6, und somit auch an dem Trägerkörper 2, gehalten. Die Magnetkraft ist so groß zu wählen, dass bei einer Rotation des Trägerkörpers 2 um die zweite Rotationsachse 4 das Werkstück 5 sich nicht löst.

In der Figur 4 ist der Außendurchmesser des Werkstückes 5 so groß wie der Außendurchmesser der äußeren Hülse 9 des Aufnahmekörpers 6 ausgestaltet. Der Kettenbolzen steht auf den miteinander fluchtenden trägerkörperfernen Ende der Hülsen 9 und des Permanentmagneten 8 senkrecht zur zweiten Rotationsachse 4.

In Fig. 5 ist ein gerades Ende eines Aufnahmekörpers 6 dargestellt. Das Werkstück 5 weist dabei einen etwas kleineren Außendurchmesser als der Außendurchmesser des Aufnahmekörpers 6 auf. Der Außendurchmesser des Werkstücks 5, also des Kettenbolzens, entspricht im Wesentlichen dem Innendurchmesser der Hülse 9. Über das Wählen der Passung, lässt sich die Haltekraft, zusätzlich zur Magnetkraft, einstellen.

In Figur 6 ist ein Werkstück 5 dargestellt, wie es stirnseitig auf dem Permanentmagneten 8, auf dessen trägerkörperfernen Seite aufsteht. Der Permanentmagnet 8 ist dabei von zwei konzentrischen Hülsen 9 umgeben.

Im Folgenden wird die Funktionsweise der Vorrichtung näher erläutert.

Ein Werkstückträger 2 mit zwei Trägerkörpern 2 wird über vertikal angeordnete Quellen, die nicht dargestellt sind, mit Werkstücken 5, insbesondere Kettenbolzen beschickt. Der Werkstückträger 1 ist dabei entweder horizontal, oder vorzugsweise vertikal angeordnet. Die Trägerkörper 2 sind vorzugsweise parallel zu einer ersten Rotationsachse 3 angeordnet.

Die einzelnen Werkstücke werden entweder manuell oder vorzugsweise automatisch auf die Aufnahmekörper 6 aufgebracht. Durch die Magnetkraft der Aufnahmekörper 6 richten sich die Werkstücke 5 orthogonal zur zweiten Rotationsachse aus, wie in den Fig. 1 und 2 dargestellt, also horizontal. Die Trägerkörper 2 rotieren dann um die erste Rotationsachse 3 und um die zweite Rotationsachse 4. Die Vakuumbeschichtungsanlage wird zum Bombardieren der Werkstücke 5 mit zur Beschichtung verwendeten Nanopartikeln aktiviert. Es werden dabei vorzugsweise PVD- oder CVD-Verfahren verwendet, die teilweise mit Plasma arbeiten.

Durch die Drehung der Werkstücke 5 ist es möglich, dass die Nanopartikel bis auf die trägerkörpernahe Stirnseite der Werkstücke 5 alle Oberflächen über den Umfang gleichmäßig beschichten, insbesondere die Mantelflächen der Werkstücke. Bei Verwendung einer Schürze, die aufgrund des Überstandes der Hülse(n) 9 über dem Permanentmagneten 8 entsteht, ist ein kleiner Bereich, ausgehend von der trägerkörpemahen Endseite des Werkstücks 5 nicht mit Nanopartikeln beschichtet. Da jedoch im Einbau der Kettenbolzen dieser Bereich nicht reibbeaufschlagt wird, ist dieser Effekt vernachlässigbar.

Es ist auch möglich, die Kettenbolzen nach einer erstmaligen Beschichtung zu drehen, so dass auch die andere Stirnseite beschichtet wird. Im Regelfall dürfte dies jedoch überflüssig sein.

Die Aufnahmekörper 6 sind separat vom Trägerkörper 2 ausgestaltet.

## Patentansprüche

1. Werkstückträger (1) für Vakuumbeschichtungsanlagen mit zumindest einem Trägerkörper (2), der um eine erste außerhalb des Trägerkörpers (2) befindliche Rotationsachse (3) drehbar gelagert ist und um eine zweite innerhalb des Trägerkörpers (2) befindliche Rotationsachse (4) drehbar gelagert ist, **dadurch gekennzeichnet, dass** der Trägerkörper (2) auf seiner Außenseite mehrere jeweils radial abstehende magnetische Aufnahmekörper (6) zur Aufnahme von zu beschichtenden Werkstücken aufweist, die an ihrer trägerkörperfernen Seite eine Aufnahmefläche (7) für das zu beschichtende Werkstück aufweisen.

2. Werkstückträger (1) nach Anspruch 1, wobei der Querschnitt der Aufnahmefläche (7) dem Querschnitt der Werkstücke (5) entspricht.

3. Werkstückträger (1) nach Anspruch 1, wobei der Querschnitt der Aufnahmekörper (6) größer als der Querschnitt der Werkstücke (5) ist.

4. Werkstückträger (1) nach einem der vorhergehenden Ansprüche, wobei die Aufnahmekörper (6) zylindrisch ausgeformt sind.

5. Werkstückträger (1) nach zumindest einem der vorhergehenden Ansprüche, wobei der Trägerkörper (2) eine Zylinderform aufweist.

6. Werkstückträger (1) nach einem der vorhergehenden Ansprüche, wobei der Aufnahmekörper (6) einen Permanentmagneten (8) umfasst.

7. Werkstückträger (1) nach zumindest einem der vorhergehenden Ansprüche, wobei der Aufnahmekörper (6) magnetisch abgeschirmt ist.

8. Werkstückträger (1) nach einem der Ansprüche 6 oder 7, wobei der Permanentmagnet (8) von zumindest einer Hülse (9) umgeben ist.

9. Werkstückträger (1) nach Anspruch 8, wobei der Permanentmagnet (8) von zwei Hülsen (9) umgeben ist, die vorzugsweise zueinander koaxial angeordnet sind.

10. Werkstückträger (1) nach Anspruch 8 oder 9, wobei die Hülse (9) aus magnetisch weichem Material besteht.

11. Werkstückträger (1) nach zumindest einem der vorhergehenden Ansprüche, wobei der Trägerkörper (2) vertikal ausgerichtet ist.

12. Werkstückträger (1) nach zumindest einem der vorhergehenden Ansprüche, wobei die zweite Rotationsachse (4) parallel zur ersten Rotationsachse (3) ausgerichtet ist.

13. Werkstückträger (1) nach einem der vorhergehenden Ansprüche, wobei die Aufnahmekörper (6) zur Aufnahme der Werkstücke (5) quer zur zweiten Rotationsachse (4) ausgerichtet sind.

14. Werkstückträger (1) nach einem der Ansprüche 1 bis 6, wobei die Aufnahmekörper (6) in Löcher einer Außenwand des Trägerkörpers (2) eingesteckt und fixiert sind.

15. Werkstückträger (1) nach Anspruch 14, wobei zwischen den Aufnahmekörpern (6) und den Löchern eine Presspassung vorliegt.

16. Werkstückträger (1) nach einem der Ansprüche 8 bis 15, wobei zwischen dem Permanentmagneten (8) und der Hülse (9) eine Presspassung vorliegt.

17. Werkstückträger (1) nach zumindest einem der vorhergehenden Ansprüche, wobei zumindest zwei Trägerkörper (2) vorhanden sind.

18. Werkstückträger (1) nach einem der vorhergehenden Ansprüche, wobei die Aufnahmekörper (6) gleichmäßig über den Trägerkörper (2) verteilt sind.

19. Werkstückträger (1) nach Anspruch 18, wobei zumindest zwei, vorzugsweise vier Aufnahmekörper (6) zueinander gleich beabstandet auf derselben Höhe des Trägerkörpers (2) angeordnet sind.

20. Werkstückträger (1) nach Anspruch 19, wobei unter und/oder über einer ersten Lage an Aufnahmekörpern weitere Lagen an Aufnahmekörpern (6) angeordnet sind, deren Aufnahmekörper (6) um 45° zu den Aufnahmekörpern (6) der ersten Lage versetzt angeordnet sind.

21. Werkstückträger (1) nach einem der Ansprüche 1 bis 20, wobei der Trägerkörper (2) über einen Motor angetrieben ist.
